Europäisches Patentamt

European Patent Office

Office européen des brevets

(19)

(11) **EP 0 874 464 A1**

(12) **EUROPEAN PATENT APPLICATION**

(43) Date of publication:
    **28.10.1998 Bulletin 1998/44**

(51) Int Cl.⁶: **H03M 3/02**

(21) Application number: **98302842.4**

(22) Date of filing: **14.04.1998**

(84) Designated Contracting States:
    **AT BE CH CY DE DK ES FI FR GB GR IE IT LI LU
    MC NL PT SE**
    Designated Extension States:
    **AL LT LV MK RO SI**

(30) Priority: **21.04.1997 US 840944**

(71) Applicant: **LSI LOGIC CORPORATION
    Milpitas, CA 95035 (US)**

(72) Inventors:
    • **Liu, Edward W.
      Sunnyvale, California 94089 (US)**
    • **Shami, Qasim-Rashid
      Fremont, California 94536 (US)**

(74) Representative: **Hallam, Arnold Vincent et al
    LEWIS & TAYLOR
    5 The Quadrant
    Coventry, CV1 2EL (GB)**

(54) **Delta-sigma converter with low order anti-aliasing filter**

(57)    A analog-to-digital conversion apparatus and method for mobile communication devices are disclosed by the present invention. Because the conventional CMOS process does not allow for high order anti-aliasing circuits to be fabricated with digital circuits on the same chip, a new apparatus had to be developed to use low order anti-aliasing circuits for the analog-to-digital conversion. The apparatus of the present invention includes a low order anti-aliasing circuit, a delta-sigma converter, and post-conversion filters. The post conversion filters include a decimation circuit, a droop correction filter, and an offset adjust circuit. In this implementation, a low order analog anti-aliasing filter can be used along with a delta-sigma converter and post-conversion filters to eliminate the need for high order analog anti-aliasing filters.

FIG. 1

## Description

## Background of the Invention

## Field of the Invention

The present invention generally relates to the art of processing electrical signals. In particular, the present invention relates to the art of filtering interference signals.

## Description of Related Art

Integrated circuits (ICs) having components to handle analog signals as well as digital signals are often referred to as mixed-signal integrated circuits (MSICs). One example of an MSIC is an IC designed to convert incoming analog signals to digital signals to be further processed by digital circuits. These are usually referred to as analog to digital converter circuits or ADC's.

To convert analog signal to digital signals without losing the information contained in the analog signal, the analog signal must be sampled at a frequency which is, at minimum, twice the highest frequency ofthe analog signal to be preserved. This requirement is often referred to as the Nyquist criteria.

For example, audio signals typically range from 20 Hz to 2,200 Hz. Analog electrical signals representing audio signals are at the same 20 to 22,000 Hz. To convert the analog signals to digital signals, the sampling frequency, $F_s$, must be at least 22,000 x 2, or 44,000 Hz.

Often, to ensure that none of the audio information of the analog signal is lost, the sampling frequency is set higher than the minimum required. As the sampling frequency increases, the fidelity of the digital data to the analog data increases, thus better preserving the information contained in the analog signal. This also means that the analog to digital conversion is less susceptible to high frequency noise in the analog signal.

On the other hand, the increase in the sampling frequency means that the A/D converter becomes more complex, operates at higher temperature, consumes more power to handled the increased frequency requirements, and produces additional digital signal output. In addition, the increase in the digital signal output forces the digital circuits to increase in complexity. As a compromise between the competing requirements, often, the sampling frequency is set at 270K Hz.

Therefore, the tendency in conventional ADC design has been to lower the sampling frequency, and reduce the susceptibility of the ADC to the high frequency noise using a high order analog filter. The high order analog filter is positioned to remove the high frequency noise in the incoming analog signal before being processed by the ADC. This technique is referred to as anti-aliasing, and the analog filter is referred to as the anti-aliasing filter.

In a wireless mobile communications environment using MSIC's, such as the GSM (Global System for Mobile communications) environment, a basedband receiver requires a SINAD (signal to noise and distortion ratio) value of 59 dB at a sampling rate of 270K samples per second. These are the industry standard specification for GSM (Global System for Mobile Communications), a worldwide digital cellular standard. At the same time, the required adjacent channel interference (ACI) rejection is at 80dB/decade with cut-off at 100KHz. For an ADC in this environment, a fourth order analog filter followed by a 10 bit ADC is .conventionally used. The fourth order analog filter is used as the anti-aliasing filter in this case.

However, the implementation of a fourth order analog filter in a standard digital CMOS process is not feasible because a standard digital CMOS process does not allow for non-silicide polysilicon resistors and capacitors with adequate capacitance per unit area as required to build a fourth order analog filters.

## Summary of the Invention

Therefore, an object of the present invention is to overcome the limitations of the digital CMOS process by designing the baseband receiver without a fourth order analog anti-aliasing filter. Instead, lower order anti-aliasing filters are implemented before the ADC process. Then, digital filters used, post ADC, to filter the high frequency noise.

The present invention discloses an integrated circuit having an anti-aliasing filter, a delta-sigma converter, and a digital filter.

The present invention discloses a single integrated CMOS (Complementary Metal Oxide Semiconductor) circuit having an analog anti-aliasing filter, a second order delta-sigma converter, and a plurality of cascaded comb digital filters for decimation of digital signals. These and other aspects, features, and advantages of the present invention will be apparent to those persons having ordinary skilled in the art to which the present invention relates from the foregoing description and the accompanying drawings.

## Brief Description of the Drawings

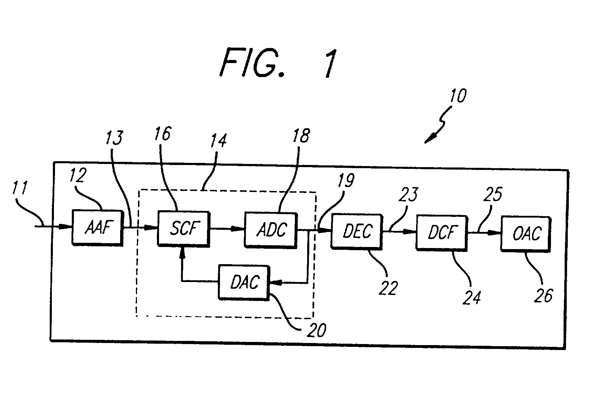

FIG. 1 is a block diagram illustrating a preferred embodiment of the present invention.

## Detailed Description of the Preferred Embodiment(s)

Referring to the drawing, particularly to Fig. 1, analog signals are fed into the receiver 10 by line 11. The anti-aliasing filter 12, AAF, removes any signals over a 100 KHz. The AAF 12 may be a first order analog filter or a second order analog filter. In particular, the AAF 12 may be implemented as a first order Sallen-Key type active filter or a second order Sallen-Key type active filter.

The filtered analog signal 13 is then read by the delta-sigma converter (DSC) 14. A high dynamic range DSC is chosen to reduce the anti-aliasing requirement for the AAF 12. The DSC 14 samples the incoming analog signal at a very fast rate, thereby reducing the requirement that the analog signal be first filtered prior to the sampling process. With an over sampled, delta-sigma, analog-to-digital data converter, the input signal is sampled at a very high frequency; therefore, the cut-off frequency of the analog filter can be very high. So, a simple one-pole filter suffices.

The standard DSC 14 has three major components - The switched-capacitor integrator, (SCF) 16, the analog-to-digital converter (ADC) 18, and the digital-to-analog converter (DAC) 20.

The SCF is a switched-capacitor integrator. The ADC generates the digital output. The DAC provides a feedback signal. The DAC output is subtracted from the input, and the difference is the error signal representing the difference between the analog input and digital output. By closing the loop, the error is eliminated and the digital output will be equal to the analog input.

Once the analog signal is sampled and quantized, the resulting signal can be filtered using a digital filter. The line 19 carries the digital samples of the analog signal 11 at 26 million samples per second. The digital samples 19 are decimated by the decimation filter 22. The decimation filter is a third order comb filter with the following transfer functions:

$$H(z) = ((1-z^{**}3)/(1-z^{**}4))^{**}3$$

Alternatively, a fourth order comb filter can be used with a 10 bit ADC.

The comb filter of the decimation filter 22 is implemented as a cascade of three accumulators, followed by a 1-in-48 sampler and 3 subtractors, and finally a 1-in-2 sampler. Together, the components of the decimation filter 22 operate to decimate the incoming 26 million samples per second to produce 270 thousand samples per second. This is a factor of 96.

The decimation of the signal 19 by the decimation filter 22 causes the signal to droop at 100KHz. The droop connection filter, DCF, 24 corrects for the droop at 100kHz caused by the decimation filter and produces the droop corrected signal 25.

The offset adjust circuit, OAC, 26, is a subtractor that subtracts the offset from the input. The offset is dismissed during power up by the microprocessor.

In summary, the analog signal along with out-of-band interference is sampled and quantized into a digital representations using a fast DSC 14. Afterwards, a digital filter system is applied to the digital representation to eliminate the out-of-band interference. Thus, a robust digital filter replaces a costly analog anti-aliasing filter.

Although the present invention has been described in detail with regarding the exemplary embodiments and drawings thereof, it should be apparent to those skilled in the art that various adaptations and modifications of the present invention may be accomplished without departing from the spirit and the scope of the invention. Accordingly, the invention is not limited to the precise embodiment shown in the drawings and described in detail hereinabove. Therefore, it is intended that all such variations not departing from the spirit of the invention be considered as within the scope thereof as limited solely by the claims appended hereto.

In the following claims, those elements which do not include the words "means for" are intended not to be interpreted under 35 U.S.C. § 112 ¶ 6.

**Claims**

1. An integrated circuit comprising:

   an analog anti-aliasing filter for filtering noise from incoming analog signal;
   a delta-sigma converter, connected to said anti-aliasing filter, for converting the filtered signal to digital signal; and
   a digital filter system connected to said delta-sigma converter for filtering the digital signal.

2. An integrated circuit chip according to claim 1 wherein said anti-aliasing filter is a Sallen-Key type filter.

3. An integrated circuit chip according to claim 1 wherein said anti-aliasing filter is a first order Sallen-Key type filter.

4. An integrated circuit chip according to claim 1 wherein said anti-aliasing filter is a second order Sallen-Key type filter.

5. An integrated circuit chip according to any of claims 1 to 4 wherein said delta-sigma converter takes 26 millions samples of the analog signal per second.

6. An integrated circuit chip according to any of claims 1 to 5 wherein said digital filter comprises a plurality of cascaded comb filters.

7. An integrated circuit chip according to any of claims 1 to 6 wherein said digital filter decimates said digital signals by a factor of 96.

8. An integrated circuit chip according to any of claims 1 to 6 wherein said digital filter system further comprises:

   a decimation filter to decimate the digital signal by a factor of 96;

a droop correction filter connected to said decimation filter to corrects for a droop at 100kHz caused by said decimation filter; and

an offset adjust circuit connected to said droop correction filter to subtract offset from said droop corrected output.

9. An integrated circuit chip according to any ofclaims 1 to 8 wherein said anti-aliasing filter is a user selectable from a group consisting of a first order Sallen-Key type active filter or a second order Sallen-Key type active filter.

10. An integrated circuit according to any of claims 1 to 9 wherein said decimation filter is a third order comb filter with the following transfer function:

$$H(z) = ((1-z^{**}3)/(1-z^{**}4))^{**}3$$

11. An integrated circuit according to claim 10 wherein said comb filter further comprises:

a cascade of three accumulators;
a 1-in-48 sampler;
three subtractors; and
a 1-2 sampler.

12. A integrated circuit CMOS chip in a mobile communications device comprising:

an analog anti-aliasing filter to filter incoming analog signal;
a second order delta-sigma converter for converting the filtered analog signal to digital signal, said delta-sigma converter taking 26 million samples of the filtered analog signal per second;
a decimation filter to decimate the digital signal by a factor of 96;
a droop correction filter connected to said decimation filter to corrects for a droop at 100kHz caused by said decimation filter; and
an offset adjust circuit connected to said droop correction filter to subtract offset from said droop corrected output.

13. An integrated circuit chip according to claim 12 wherein said anti-aliasing filter is a Sallen-Key type filter.

14. An integrated circuit chip according to claim 12 wherein said anti-aliasing filter is a first order Sallen-Key type filter.

15. An integrated circuit chip according to claim 12 wherein said anti-aliasing filter is a second order Sallen-Key type filter.

16. An integrated circuit according to any of claims 12 to 15 wherein said decimation filter further comprises a plurality of cascaded comb filters for digital decimation of said 26 million digital samples by a factor of 96 to produce a 270 thousand decimated samples per second.

17. An integrated circuit according to any of claims 12 to 16 wherein said decimation filter is a third order comb filter with the following transfer function:

$$H(z) = ((1-z^{**}3)/(1-z^{**}4))^{**}3$$

18. An integrated circuit according to claim 17 wherein said comb filter further comprises:

a cascade of three accumulators;
a 1-in-48 sampler;
three subtractors; and
a 1-2 sampler.

19. A method of converting analog signals to digital signals, said method comprising steps:

filtering the analog signal with a low order anti-aliasing filter;
sampling the filtered analog signal using a delta-sigma converter;
decimating the samples using a plurality of cascaded comb filters

20. A method according to claim 19 wherein said delta-sigma converter takes 26 million digital samples of the filtered analog signal per second.

21. A method according to claim 19 or 20 wherein said decimation step decimates the samples by a factor of by a factor of 96.

22. A method according to claim 19, 20 or 21 further comprising the step of correcting the decimated sample for a droop at 100 KHz.

23. A method according to claim 22 further comprising the step of subtracting an offset .from said droop corrected sample.

24. A method according to any of claims 19 to 23 wherein said step of anti-aliasing filter is a Sallen-Key type filter.

25. A method according to any of claims 19 to 23 wherein said step of anti-aliasing filter is a first order Sallen-Key type filter.

26. A method according to any of claims 19 to 23 wherein said step of anti-aliasing filter is a second order Sallen-Key type filter.

EP 0 874 464 A1

# FIG. 1

EP 0 874 464 A1

**European Patent Office**

**EUROPEAN SEARCH REPORT**

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X | EP 0 554 701 A (ROCKWELL INTERNATIONAL) 11 August 1993 | 1,5,7,8, 10,19-22 | H03M3/02 |
| Y | * abstract; figure 7 * | 2-4,6,9, 17,24-26 | |
| A | | 12 | |
| | --- | | |
| X | WO 93 07679 A (ELBIT-ATI) 15 April 1993 | 1,19 | |
| | * page 3, line 28 - line 33 * | | |
| | * page 8, line 10 - line 27 * | | |
| | * page 10, line 16 - line 24 * | | |
| | * page 12, line 2 - line 7 * | | |
| | * figure 4 * | | |
| A | | 12 | |
| | --- | | |
| Y | EP 0 096 857 A (INTERNATIONAL STANDARD CORPORATION) 28 December 1983 | 2-4,9, 24-26 | |
| A | * page 8, line 9 - line 19; figure 1 * | 13-15 | |
| | --- | | |
| Y | I. FUJIMORI ET AL.: "A 5-V single chip delta-sigma audio A/D converter with 111 dB dynamic range" IEEE JOURNAL OF SOLID STATE CIRCUIT, vol. 32, no. 3, March 1997, NY, US, pages 329-336, XP000692863 * paragraph IV; figure 6 * | 6,17 | TECHNICAL FIELDS SEARCHED (Int.Cl.6) H03M |
| | --- | | |
| A | O.J.A.P NYS ET AL.: "On configurable oversampled A/D converters" IEEE JOURNAL OF SOLID STATE CIRCUITS, vol. 28, no. 7, July 1993, NY, US, pages 736-742, XP000322302 * paragraph VI * | 8,12,23 | |
| | ----- | | |

The present search report has been drawn up for all claims

| Place of search | Date of completion of the search | Examiner |
|---|---|---|
| MUNICH | 20 July 1998 | Augarde, E |

EPO FORM 1503 03.82 (P04C01)